# EUROPÄISCHE PATENTSCHRIFT

(11) **EP 3 794 730 B1**
(45) Veröffentlichungstag und Bekanntmachung des Hinweises auf die Patenterteilung: **11.05.2022**
(21) Anmeldenummer: 19778857.3
(22) Anmeldetag: 17.09.2019
(51) Int. Cl.: H03K 17/0814, H03K 17/12, H03K 17/10, H03K 17/16, H02M 1/34

(54) **SCHALTVORRICHTUNG ZUM AUFTRENNEN EINES STROMPFADS**
SWITCHING DEVICE FOR SEPARATING A CURRENT PATH
DISPOSITIF DE COMMUTATION DESTINÉ À COUPER UN CIRCUIT DE COURANT

(30) Priorität: 18.09.2018 DE 102018215827
(43) Veröffentlichungstag der Anmeldung: 24.03.2021
(73) Patentinhaber: Siemens Aktiengesellschaft, 80333 München (DE)
(72) Erfinder: RUPP, Jürgen, "verstorben" (DE)
(86) Internationale Anmeldenummer: PCT/EP2019/074758
(87) Internationale Veröffentlichungsnummer: WO 2020/058212

(56) Entgegenhaltungen:
- WO-A1-02/23704
- WO-A1-2017/055243
- WO-A1-2018/158233

## Beschreibung

Die Erfindung betrifft eine Schaltvorrichtung zum Auftrennen eines quell- und lastseitige Induktivitäten umfassenden Strompfads eines Gleichspannungsnetzes.

Eine Schaltvorrichtung, die zum Auftrennen eines quell- und lastseitige Induktivitäten umfassenden Strompfads eines Gleichspannungsnetzes vorgesehen ist, muss die Rückspeisung oder den Abbau von Energie aus dem Gleichspannungsnetz handhaben können.

Werden mechanische Schalter oder Hybridschalter mit mechanischem und elektronischem Schaltelement eingesetzt, so besteht die Gefahr der Entstehung eines Lichtbogens, sofern nicht sichergestellt werden kann, dass das Auftrennen des Strompfads im Nulldurchgang des Stroms erfolgt. Ein solches mechanisches Schaltelement muss daher durch eine aufwändige Beschaltung, z.B. durch das Vorsehen mehrerer Halbleiterschaltelemente und Varistoren als Überspannungsbegrenzer, geschützt werden. Dazu kann beispielsweise der im Hauptstromzweig liegende, schnell schaltende mechanische Schalter mit einem Halbleiterschaltelement, das im Durchlassfall einen geringen Spannungsabfall aufweist, verschaltet werden. Die Aufgabe dieses Halbleiterschaltelements beim Auftrennen des Lastpfads besteht darin, bei der Abschaltung einen Spannungsabfall zu erzeugen, damit der Strom in einen zu dieser Anordnung parallel geschalteten Hauptschalter geführt werden kann. Dieser Hauptschalter besteht aus einer Serienschaltung mehrerer Halbleiterschaltelemente, zu deren Überspannungsschutz jeweils ein Varistor parallel geschaltet ist. Fließt nun der Strom im Wesentlichen über den parallelen Pfad, so kann der schnelle mechanische Schalter ausgeschaltet werden, ohne dass ein Lichtbogen entsteht. Nachteil dieser Schaltvorrichtung ist die Komplexität aufgrund der Vielzahl an benötigten Halbleiterschaltelementen und Varistoren, wobei letztere sehr teuer und schwer sind.

Es sind auch Schaltvorrichtungen bekannt, die ausschließlich steuerbare Halbleiterschaltelemente, z.B. IGBTs umfassen. Bei dieser Variante können für einen bidirektionalen Betrieb beispielsweise zwei Halbleiterschaltelemente anti-seriell in den Lastpfad geschaltet werden. Ohne weitere Maßnahmen kann diese Schaltvorrichtung jedoch nur in Gleichspannungsnetzen eingesetzt werden, welche keine großen Induktivitäten aufweisen. Zudem werden spannungsbegrenzende Elemente, wie z.B. Varistoren und dergleichen, erforderlich, welche jedoch aus Kostengründen ungern verwendet werden.

Aus der WO2018158233 der Anmelderin ist eine Schaltvorrichtung bekannt, die die oben genannten Probleme löst. Die Schaltvorrichtung umfasst zumindest zwei in Serie verschaltete Schaltmodule. Jedes der Schaltmodule umfasst zumindest ein steuerbares Halbleiterschaltelement in Gestalt eines IGBTs (Insulated Gate Bipolar Transistor), dem eine Serienschaltung aus einem Widerstand und einem Kondensator parallel geschaltet ist. Eine derartige Schaltvorrichtung ermöglicht einen "weichen" Abschaltvorgang, bei dem der Stromfluss in dem Strompfad nicht abrupt, sondern rampenförmig abgebaut wird. Durch wenigstens eines der zumindest zwei Schaltmodule wird eine Gegenspannung im Strompfad aufgebaut. Dies wird durch einen Betrieb des jeweiligen Halbleiterschalterelements der Schaltmodule im getakteten Bereich ermöglicht. Damit wird die hohe Verlustleistung im Abschaltfall nicht in dem Halbleiterschaltelement der jeweiligen Schaltmodule umgesetzt, sondern überwiegend in dem Widerstand der jeweiligen Schaltmodule. Die Schaltvorrichtung kann dadurch auf spannungsbegrenzende Bauelemente, wie Varistoren, verzichten, die teuer, schwer und bauraumintensiv sind. Das Halbleiterschaltelement in den jeweiligen Schaltmodulen übernimmt dabei die Rolle des Bremschoppers.

Ein Nachteil dieser Schaltvorrichtung besteht darin, dass über das steuerbare Halbleiterschaltelement nicht nur der Laststrom, sondern auch der Entladestrom des Kondensators geführt wird. Das Führen des Entladestroms geschieht zwar nur kurzzeitig während des Ausschaltvorgangs. IGBTs sind aber nur im geringen Maß überstromtragfähig. Daher müssen diese auf den Worst Case, d.h. den maximal möglichen Summenstrom aus Laststrom und Entladestrom, ausgelegt werden, was den Einsatz groß dimensionierter Bauelemente erforderlich macht. Dadurch wird die Schaltvorrichtung unerwünscht teuer.

Es ist Aufgabe der Erfindung, eine Schaltvorrichtung zum Auftrennen eines quell- und lastseitige Induktivitäten umfassenden Strompfads eines Gleichspannungsnetzes anzugeben, welche baulich und/oder funktionell weiter verbessert ist und keine Überdimensionierung von Bauelementen erfordert. Insbesondere soll die Schaltvorrichtung mit geringeren Kosten bereitstellbar sein.

Diese Aufgabe wird gelöst durch eine Schaltvorrichtung gemäß den Merkmalen des Patentanspruchs 1. Vorteilhafte Ausgestaltungen ergeben sich aus den abhängigen Ansprüchen.

Es wird eine Schaltvorrichtung zum Auftrennen eines quell-und lastseitige Induktivitäten umfassenden Strompfads eines Gleichspannungsnetzes vorgeschlagen, die zumindest zwei in Serie verschaltete Schaltmodule umfasst. Jedes der Schaltmodule umfasst zumindest ein steuerbares Halbleiterschaltelement, dem eine Serienschaltung aus einem Widerstand und einem Kondensator parallel geschaltet ist. Die Schaltvorrichtung bildet die aus der WO2018158233 bekannte Schaltvorrichtung dadurch weiter, dass der Widerstand aus einer Serienschaltung von zwei seriell miteinander verschalteten Widerständen gebildet ist. Ein erstes Ende der Serienschaltung ist mit einem ersten Lastanschluss des steuerbaren Halbleiterschaltelements verschaltet. Ein zweites Ende der Serienschaltung ist mit dem Kondensator verschaltet. Jedes der Schaltmodule umfasst ferner ein weiteres steuerbares Halbleiterschaltelement. Das weitere steuerbare Halbleiterschaltelement ist direkt zwischen einem ersten Knotenpunkt der beiden Widerstände der Serienschaltung und einem zweiten Knotenpunkt verschaltet, der den Kondensator mit einem zweiten Lastanschluss des steuerbaren Halbleiterschaltelements verbindet.

Bei einer derart ausgebildeten Schaltvorrichtung fließt der Laststrom, wie bei der bekannten Schaltvorrichtung, über das steuerbare Halbleiterschaltelement. Der Entladestrom zur Entladung des Kondensators des Schaltmoduls wird demgegenüber von dem weiteren steuerbaren Halbleiterschaltelement übernommen. Dadurch kann das steuerbare Halbleiterschaltelement, das den Laststrom führt, auf die Höhe des Laststroms dimensioniert werden. Eine Überdimensionierung, wie bei der bekannten Schaltvorrichtung, ist nicht erforderlich. Die dadurch bereitgestellte Schaltvorrichtung weist trotz der zusätzlichen Bauelemente geringere Kosten auf.

Als weiteres steuerbares Halbleiterschaltelement wird gemäß einer zweckmäßigen Ausgestaltung ein solches steuerbares Halbleiterschaltelement verwendet, das über ein Ansteuersignal leitend und sperrend schaltbar ist. Beispielsweise kann das weitere steuerbare Halbleiterschaltelement ein Bipolartransistor mit isolierter Gate-Elektrode (IGBT) sein. Wird das weitere steuerbare Halbleiterschaltelement als IGBT ausgeführt, ergeben sich mehr Freiheitsgrade bei der Ansteuerung. Neben der Funktion, den Entladestrom des Kondensators des Schaltmoduls zu tragen, kann auch ein dauerhafter Stromfluss über das weitere steuerbare Halbleiterschaltelement realisiert werden. Der dem weiteren steuerbaren Halbleiterschaltelement vorgeschaltete Widerstand der Serienschaltung der Widerstände kann dann beispielsweise zur Dämpfung von Netzschwingungen oder als Ladewiderstand für kapazitive Lasten verwendet werden.

In einer alternativen Ausgestaltung ist das weitere steuerbare Halbleiterschaltelement ein Thyristor. Die Verwendung eines Thyristors als weiteres steuerbares Halbleiterschaltelement weist den Vorteil auf, dass dieser kurzzeitig sehr hoch überlastbar ist, so dass ein relativ kleiner Typ verwendet werden kann. Dadurch kann die Schaltvorrichtung mit geringen Kosten realisiert werden.

Gemäß einer Ausgestaltung ist der Thyristor vom abschaltbaren Typ, wie z.B. ein GTO (Gate Turn-Off)-Thyristor oder ein IGCT (Integrated Gate-Commutated Thyristor). Durch die Verwendung eines Thyristors vom abschaltbaren Typ ist es möglich, den Stromfluss durch den Strompfad des weiteren steuerbaren Halbleiterschaltelements gezielt zu beenden.

Soll kein Thyristor vom abschaltbaren Typ eingesetzt werden, insbesondere aufgrund hoher Kosten und/oder schlechter Verfügbarkeit, so kann der Thyristor alternativ mittels eines Löschkreises gelöscht werden. Insbesondere ist dabei das steuerbare Halbleiterschaltelement, das den Laststrom der Schaltvorrichtung trägt, ein Element des Löschkreises. Dadurch kann die Anzahl zusätzlicher Elemente gering gehalten werden.

Zweckmäßigerweise umfasst der Löschkreis einen weiteren Kondensator, der zwischen dem ersten Knotenpunkt und dem ersten Lastanschluss des steuerbaren Halbleiterschaltelements verschaltet ist. Dem Widerstand der Serienschaltung der Widerstände, welcher in Serie zu dem weiteren steuerbaren Halbleiterschaltelement verschaltet ist, wird damit ein weiterer Kondensator parallel geschaltet, der beim Einschalten des steuerbaren Halbleiterschaltelements einen kurzen negativen Spannungsstoß über dem Thyristor erzeugt, so dass der Strom im Thyristor zu null wird. Auf diese Weise kann mit geringem Aufwand ein Löschen des Thyristors erzielt werden.

Gemäß einer weiteren zweckmäßigen Ausgestaltung ist eine gewünschte Entladezeit des Kondensators durch das Verhältnis der Widerstandswerte der Widerstände der Serienschaltung eingestellt. Beim Laden des Kondensators wirkt der Widerstandswert, der sich aus der Summe der Widerstandswerte der beiden Widerstände der Serienschaltung der Widerstände ergibt. Demgegenüber wirkt beim Entladen des Kondensators lediglich der Widerstandswert desjenigen Widerstands, welcher in dem Parallel-Zweig zu dem weiteren steuerbaren Halbleiterschaltelement enthalten ist.

Gemäß einer weiteren zweckmäßigen Ausgestaltung weist der weitere Kondensator einen Kapazitätswert auf, der kleiner als der Kapazitätswert des Kondensators des Schaltmoduls ist.

Die beschriebene Schaltvorrichtung ist insbesondere für die Verwendung in einem Gleichspannungsnetz mit einer Spannung von mehr als 1000 V vorgesehen. In Abhängigkeit der in dem Gleichspannungsnetz vorherrschenden Spannung muss dann eine geeignete entsprechende Anzahl an Schaltmodulen der Schaltvorrichtung gewählt werden. Je höher die zu beherrschende Spannung in dem Gleichspannungsnetz ist, desto größer wird - gleiche Halbleiterschaltelemente vorausgesetzt - die Anzahl der Schaltmodule gewählt. Bei Gleichspannungsnetzen im Mittelspannungsbereich können insbesondere IGBTs oder MOSFETs als steuerbare Halbleiterschaltelement für das Schalten des Laststroms zum Einsatz kommen. Bei noch höheren Spannungen kommen insbesondere Thyristoren mit einer Abschalteinrichtung oder IGCTs zum Einsatz. Eine weitere Ausgestaltung sieht vor, dass die Schaltvorrichtung der hier beschriebenen Art als Kurzschlussfester Leistungsschalter verwendet wird.

Die Erfindung wird nachfolgend näher anhand von Ausführungsbeispielen in der Zeichnung erläutert. Es zeigen:
- Fig. 1: ein elektrisches Ersatzschaltbild, das den Aufbau eines einzelnen unidirektionalen Schaltmoduls für eine bekannte Schaltvorrichtung zeigt;
- Fig. 2: ein elektrisches Ersatzschaltbild einer seriellen Verschaltung von drei in Fig. 1 gezeigten Schaltmodulen;
- Fig. 3: ein elektrisches Ersatzschaltbild einer erfindungsgemäßen Schaltvorrichtung in einem Gleichspannungsnetz mit quell- und lastseitigen Induktivitäten;
- Fig. 4: ein erstes Ausführungsbeispiel eines verbesserten erfindungsgemäßen Schaltmoduls;
- Fig. 5: ein zweites Ausführungsbeispiel eines verbesserten erfindungsgemäßen Schaltmoduls; und
- Fig. 6: ein Diagramm, das den Verlauf von Spannung und Strom durch ein weiteres steuerbares Halbleiterschaltelement zeigt; und
- Fig. 7: ein drittes Ausführungsbeispiel eines erfindungsgemäßen Schaltmoduls, das einen bidirektionalen Betrieb erlaubt.

In der nachfolgenden Beschreibung sind gleiche Elemente mit gleichen Bezugszeichen versehen.

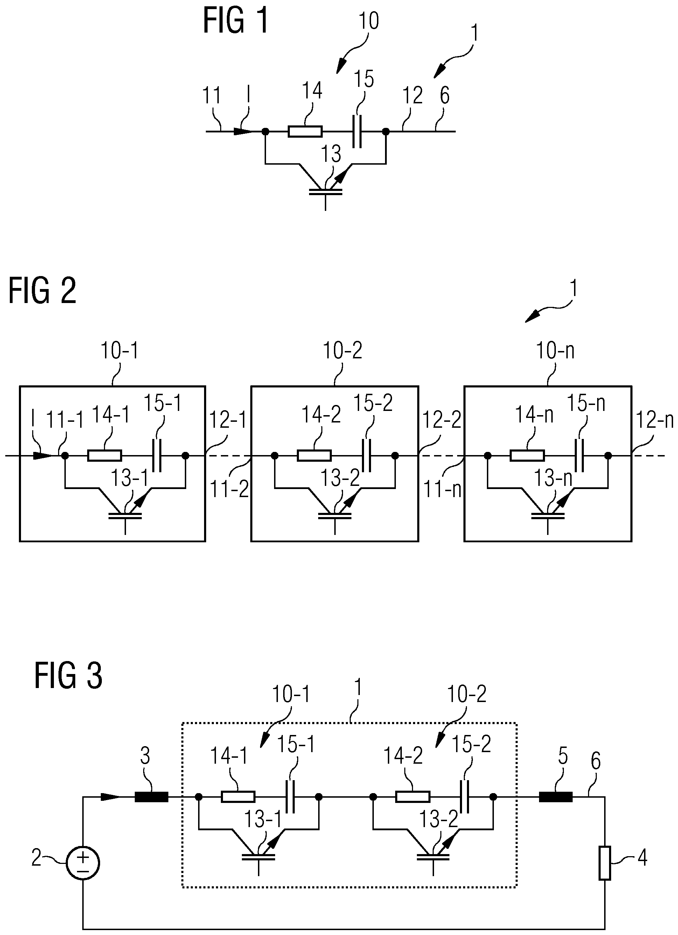

Fig. 1 zeigt den schematischen Aufbau eines Schaltmoduls 10 einer aus der WO2018158233 bekannten Schaltvorrichtung 1 zum Auftrennen eines quell- und lastseitige Induktivitäten umfassenden Strompfads 6. Das Schaltmodul 10 umfasst ein steuerbares Halbleiterschaltelement 13. Das steuerbare Halbleiterschaltelement 13 kann ein IGBT, ein MOSFET, ein IGCT oder ein Thyristor mit einer Abschaltvorrichtung sein. Die Lastanschlüsse des steuerbaren Halbleiterschaltelements 13 sind zwischen einem ersten Schaltmodulanschluss 11 und einem zweiten Schaltmodulanschluss 12 verschaltet. Zwischen dem ersten und dem zweiten Schaltmodulanschluss 11, 12 ist ferner eine Reihenschaltung aus einem Widerstand 14 und einem Kondensator 15 angeordnet. Mit anderen Worten ist ein aus dem Widerstand 14 und dem Kondensator 15 gebildetes RC-Glied parallel zu den Lastanschlüssen des steuerbaren Schaltelements 13 geschaltet. Die antiseriell zum IGBT vorhandene Diode ist aus Gründen der Übersichtlichkeit nicht dargestellt. Das Modul kann für bidirektionalen Betrieb ertüchtigt werden, wenn das Schaltelement 13 aus zwei antiseriell verschalteten IGBTs aufgebaut wird.

Die prinzipielle Funktionsweise eines solchen einzelnen Schaltmoduls der Schaltvorrichtung 1 ist wie folgt: Soll die Schaltvorrichtung 1 Strom führen, so ist das steuerbare Halbleiterschaltelement 13 leitend geschaltet. Sobald der Strompfad 6 mit Hilfe der Schaltvorrichtung 1 aufgetrennt werden soll, wird das steuerbare Halbleiterschaltelement 13 durch eine in den Figuren nicht gezeigte Steuervorrichtung sperrend geschaltet. Dadurch kann der in dem Strompfad 6 fließende Strom I nur noch über das aus dem Widerstand 14 und dem Kondensator 15 gebildete RC-Glied weiter fließen. Der Kondensator 15 lädt sich infolge des in ihn fließenden Stroms I auf, bis ein vorgegebener oberer Schwellwert der über ihm abfallenden Spannung erreicht ist. Hierzu kann eine entsprechende Messvorrichtung (nicht dargestellt) in dem Schaltmodul 10 vorgesehen sein. Sobald der vorgegebene obere Schwellwert erreicht ist, wird das steuerbare Halbleiterschaltelement 13 wieder leitend geschaltet. Dadurch kann sich der Kondensator 15 über den Widerstand 14 und das steuerbare Halbleiterschaltelement 13 entladen. Sobald ein vorgegebener unterer Schwellwert der über dem Kondensator 15 abfallenden Spannung erreicht ist, wird das steuerbare Halbleiterschaltelement 13 mittels seiner Steuervorrichtung wieder leitend geschaltet. Das steuerbare Halbleiterschaltelement 13 muss daher nicht nur auf den zu führenden (Last)Strom I ausgelegt sein, sondern auch auf den aus der Entladung des Kondensators 13 resultierenden Entladestrom.

Erfolgt die Auftrennung des Strompfades 6 aufgrund eines in dem Gleichspannungsnetz auftretenden Kurzschlusses, so wird durch das Wiedereinschalten (leitend Schalten des steuerbaren Halbleiterschaltelements 13) es dem Kurzschlussstrom ermöglicht wieder durch das Schaltmodul 10 zu fließen. Da die Einschaltdauer des steuerbaren Halbleiterschaltelements 13 jedoch sehr kurz ist, wird der in dem Strompfad 6 fließende Strom I im Mittel abgebaut, weil die in Fig. 1 nicht gezeigten quell- und lastseitigen Induktivitäten 3 bzw. 5 (vergl. Fig. 3) einen zu schnellen Anstieg des Stroms verhindern.

Würde die Schaltvorrichtung 1 lediglich ein einziges Schaltmodul 1, wie in Fig. 1 dargestellt, umfassen, so können lediglich Spannungen beherrscht werden, die kleiner sind als die Maximalspannung des steuerbaren Halbleiterschaltelements 13. Bei größeren auftretenden Spannungen in Folge eines schnellen Abschaltvorgangs und dem Auftreten einer Überspannung aufgrund der in dem Strompfad vorhandenen Induktivitäten, könnte das steuerbare Halbleiterschaltelement 13 zerstört werden. Das Vorsehen eines einzigen Schaltmoduls 10 in der Schaltvorrichtung 1 ist grundsätzlich möglich, jedoch nur dann zweckmäßig, wenn das Gleichspannungsnetz hohe Impedanzen aufweist.

Um mit Hilfe der vorgeschlagenen Schaltvorrichtung 1 zum Auftrennen eines Strompfands eines Gleichspannungsnetzes mit höheren Spannungen realisieren zu können, ist daher gemäß Fig. 2 das serielle Verschalten einer Mehrzahl an wie in Fig. 1 gezeigten Schaltmodulen vorgesehen.

Fig. 2 zeigt ein elektrisches Ersatzschaltbild einer seriellen Verschaltung von n Schaltmodulen 10-1, 10-2, ..., 10-n (allgemein: 10-i, wobei i = 1 bis n). Jedes der Schaltmodule 10-i ist in der wie in Fig. 1 beschriebenen Weise aufgebaut. Die serielle Verschaltung der Schaltmodule 10-i erfolgt dabei derart, dass der zweite Schaltmodulanschluss 12-1 des ersten Schaltmoduls 10-1 mit dem ersten Schaltmodulanschluss 11-2 des nachfolgenden Schaltmoduls 10-2 verbunden ist, und so weiter. Der erste Schaltmodulanschluss 11-1 des ersten Schaltmoduls 10-1 ist, wie in Fig. 3 gezeigt, über eine quellseitige Induktivität 3 mit einer Gleichspannungsquelle 2 verbunden. Bei der Gleichspannungsquelle 2 kann es sich beispielsweise um eine Energieerzeugungseinheit, z.B. eine Photovoltaikanlage, ein Speichersystem, ein Batterieladegerät, eine Windenergieanlage, einen Gleichrichter und dergleichen handeln. Der zweite Schaltmodulanschluss 12-n des letzten Schaltmoduls 10-n ist, wie in Fig. 3 gezeigt, über eine lastseitige Induktivität 6 mit einer Last 4 verschaltet. Bei der Last 4 kann es sich beispielsweise um einen Antrieb eines Gleichspannungsnetzes o.ä. handeln.

Fig. 3 zeigt das elektrische Ersatzschaltbild einer Schaltvorrichtung 1, welche aus zwei seriell miteinander verschalteten Schaltmodulen 10-1 und 10-2 besteht, welche jeweils wie in Fig. 1 beschrieben, aufgebaut sind. Die Schaltvorrichtung 1 ist über die bereits erwähnte quellseitige Induktivität 3 mit der Gleichspannungsquelle 2 verbunden. Ausgangsseitig ist die Schaltvorrichtung 1 über die lastseitige Induktivität 5 mit der Last 4 verbunden. Die quell- und lastseitigen Induktivitäten 3, 5 müssen nicht zwingend physikalische Komponenten des Gleichspannungsnetzes darstellen. Die quell- und lastseitigen Induktivitäten 3, 5 können auch Leitungsinduktivitäten sein.

Die Funktionsweise der in Fig. 3 gezeigten Schaltvorrichtung ist wie folgt: Wenn die Last 4 aus der Gleichspannungsquelle 2 mit Strom versorgt werden soll, sind die steuerbaren Halbleiterschaltelemente 13-1, 13-2 (allgemein: 13-i, i = 1 bis 2) der Schaltmodule 10-1, 10-2 (allgemein: 10-i, i = 1 bis 2) leitend geschaltet. Sobald der Strompfad 6, z.B. aufgrund eines lastseitigen Kurzschlusses aufgetrennt werden soll, werden zunächst beide steuerbaren Halbleiterschaltelemente 13-i sperrend geschaltet, so dass der Strom I nur noch über die beiden RC-Glieder der Schaltmodule 10-i fließen kann. Die Kondensatoren 15-1, 15-2 (allgemein: 15-i, i = 1 bis 2) laden sich auf, bis ein jeweiliger vorgegebener oberer Schwellwert erreicht ist. Der vorgegebene obere Schwellwert kann für beide Kondensatoren 15-i gleich oder unterschiedlich gewählt sein. Zunächst wird eines der steuerbaren Halbleiterschaltelemente 13-1 oder 13-2 des Schaltmoduls 10-1 oder 10-2 wieder leitend geschaltet, so dass sich der zugeordnete Kondensator 15-1 oder 15-2 über den seriellen Widerstand 14-1 bzw. 14-2 entlädt. Sobald ein vorgegebener unterer Schwellwert erreicht ist, wird das entsprechende steuerbare Halbleiterschaltelement wieder sperrend geschaltet. Gleichzeitig oder zeitversetzt kurz danach wird das andere steuerbare Halbleiterschaltelement 13-2 oder 13-1 leitend geschaltet, wenn sein vorgegebener oberer Schwellwert erreicht ist. Auf diese Weise werden die beiden steuerbaren Halbleiterschaltelemente 13-1, 13-2 abwechselnd leitend geschaltet und damit sichergestellt, dass über beiden steuerbaren Halbleiterschaltelementen 13-i zusammen eine Summenspannung U_{ges} liegt, mit der der Stromfluss und damit die in den Induktivitäten 3, 5 gespeicherte Energie abgebaut wird.

Anders als bei der Verwendung eines einzigen Schaltmoduls liegt bei einer Mehrzahl von Schaltmodulen immer eine Gegenspannung (d.h. eine entgegen der Spannungsrichtung der Gleichspannungsquelle 2 gerichtete Spannung) im Gleichspannungsnetz an. Wenn die Anzahl n der in Serie verschalteten Schaltmodule sehr groß ist, fällt das kurzzeitige Kurzschließen eines Schaltmoduls kaum ins Gewicht, wodurch sich der Strom allmählich abbaut.

Sobald die vorgegebene obere Schaltschwelle in allen steuerbaren Halbleiterschaltelementen 13-i nicht mehr erreicht wird, bleiben alle steuerbaren Halbleiterschaltelemente 13-i der Schaltmodule 10-i dauerhaft gesperrt. Die Spannung im Gleichspannungsnetz schwingt dann mit Eigenresonanz aus.

Das beschriebene Vorgehen, wird unabhängig davon, wie groß die Anzahl n der in Reihe verschalteten Schaltmodule ist, in entsprechender Weise durchgeführt. Welche der steuerbaren Halbleiterschaltelemente 13-i zu einem gegebene Zeitpunkt sperrend und welche anderen steuerbaren Halbleiterschaltelement 13-i leitend geschaltet sind, kann entweder unter gezielter Steuerung der erwähnten, jedoch nicht gezeigten Steuereinheit erfolgen. Ebenso kann durch die geeignete, unterschiedliche Wahl jeweiliger oberer Schaltschwellen das zeitliche Verhalten des Ein- und Ausschaltens des zugeordneten steuerbaren Halbleiterschaltelements beeinflusst werden.

In einer anderen Alternative kann die über den jeweiligen Kondensatoren 15-i anliegende Spannung durch entsprechende Messmittel (nicht gezeigt) überwacht werden. Dabei wird das dem Kondensator, bei dem die höchste Spannung anliegt, zugeordnete steuerbare Halbleiterschaltelement leitend geschaltet, bis der vorgegebene untere Schwellwert erreicht ist. Da zu unterschiedlichen Zeitpunkten immer unterschiedliche Schaltmodule bzw. deren Kondensatoren eine höchste Spannung aufweisen, ergibt sich ein mehr oder minder zufälliges Ein-und Ausschalten der steuerbaren Halbleiterschaltelemente 13-i der Schaltmodule 10-i.

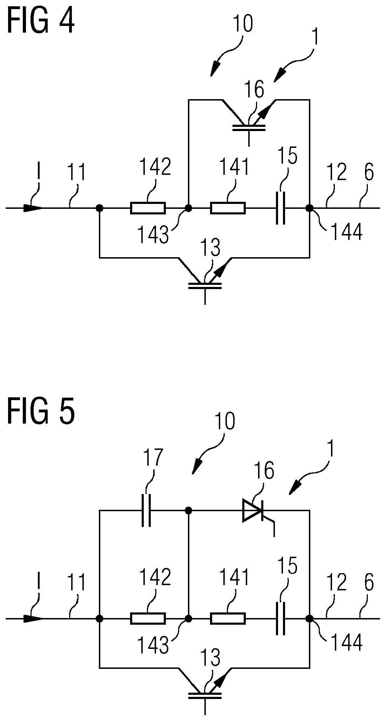

Die Figuren 4 und 5 zeigen die elektrischen Ersatzschaltbilder zweier Ausführungsbeispiele einer verbesserten Schaltvorrichtung 1, bei denen die Dimensionierung des steuerbaren Halbleiterschaltelements 13 unabhängig von dem durch die Entladung des Kondensators 15 resultierenden Entladestroms erfolgen kann. Mit anderen Worten ist bei den verbesserten Schaltvorrichtungen 1 gemäß der Erfindung das steuerbare Halbleiterschaltelement 13 in erster Linie für die Führung des Laststromes I zuständig und kann auf diesen hin dimensioniert werden. Der aus der Entladung des Kondensators 15 resultierende Entladestrom wird über ein weiteres steuerbares Halbleiterschaltelement 16 übernommen. Dies kann, wie im Ausführungsbeispiel gemäß Fig. 4 gezeigt, ein IGBT oder, wie im Ausführungsbeispiel gemäß Fig. 5 gezeigt, ein Thyristor sein.

In Abwandlung der aus Fig. 1 bekannten Schaltvorrichtung 1 ist der Widerstand 14 aus einer Serienschaltung von zwei seriell miteinander verschalteten Widerständen 141, 142 gebildet. Ein erstes Ende der Serienschaltung ist mit einem ersten Lastanschluss des steuerbaren Halbleiterschaltelements 13 und damit dem ersten Schaltmodulanschluss 11 verschaltet. Ein zweites Ende der Serienschaltung ist mit dem Kondensator 15 verschaltet. Der IGBT gemäß Fig. 4 ist zwischen einem ersten Knotenpunkt 143 der Widerstände 141, 142 der Serienschaltung und einem zweiten Knotenpunkt 144, der den zweiten Schaltmodulanschluss 12 darstellt, verschaltet. Der zweite Knotenpunkt 144 bzw. der zweite Schaltmodulanschluss 12 verbindet den Kondensator 15 mit dem zweiten Lastanschluss des steuerbaren Halbleiterschaltelements 13.

Der IGBT 16 und das steuerbare Schaltelement 13 können in etwa zum gleichen Zeitpunkt geschaltet werden. Eine Entladung des Kondensators 15 erfolgt dann über den Widerstand 141 und dem IGBT 16. Das Laden des Kondensators bei sperrend geschalteten Halbleiterschaltelementen 13, 16 erfolgt demgegenüber über beide Widerstände 141, 142. Durch Wahl des Widerstandswertes 141 kann die Entladezeit des Kondensators 15 eingestellt werden.

Gemäß der in Fig. 4 gezeigten Lösung ergeben sich Freiheitsgrade bei der Ansteuerung, da der IGBT präzise ohne weitere Komponenten steuerbar ist. Neben der reinen Entladefunktion für den Kondensator 15 kann auch ein dauerhafter Stromfluss durch den Widerstand 142 und dem IGBT 16 realisiert werden. Der Widerstand 142 kann damit beispielsweise zur Dämpfung von Netzschwingungen oder als Ladewiderstand für kapazitive Lasten verwendet werden.

In der in Fig. 5 dargestellten Realisierungsvariante ist als weiteres steuerbares Halbleiterschaltelement ein Thyristor 16 dargestellt, der zu geringeren Kosten als ein IGBT bereitgestellt werden kann. Darüber hinaus weisen Thyristoren gegenüber IGBTs den Vorteil auf, dass diese kurzzeitig sehr hoch überlastbar sind, so dass der Thyristor klein dimensioniert werden kann.

Ein bekannter Nachteil von Thyristoren ist, dass ein Gleichstrom nicht von selbst verlischt, so dass der Laststrom I auch nach der Entladung des Kondensators 15 und bei gesperrtem steuerbarem Halbleiterschaltelement 13 weiter fließen würde. Um dieses Problem zu lösen, kann als Thyristor 13 ein Thyristor vom abschaltbaren Typ, z.B. ein GTO oder IGCT, eingesetzt werden. Diese weisen jedoch den Nachteil hoher Kosten und schlechter Verfügbarkeit auf. Alternativ kann auch ein sog. Löschkreis über dem Thyristor 16 angeordnet werden. Die in Fig. 5 gezeigte Variante nutzt die bereits vorhandenen Elemente der Schaltvorrichtung und stellt im Zusammenspiel mit einem weiteren Kondensator 17 einen solchen Löschkreis bereit. Der Löschkreis dient dazu, einen Kurzschluss des Thyristors zu erzeugen. Der weitere Kondensator 17 ist dem Widerstand 142 parallel geschaltet. Dies bedeutet, der Kondensator 17 ist zwischen dem ersten Schaltmodulanschluss 11 und dem ersten Knotenpunkt 143 verschaltet. Der Kapazitätswert des weiteren Kondensators 17 ist kleiner als der Kapazitätswert des Kondensators 15. Mit Hilfe des weiteren Kondensators 17, der beim Einschalten des steuerbaren Halbleiterschaltelements 13 einen kurzen negativen Spannungsstoß über den Thyristor 16 erzeugt, wird der Strom zu null, wodurch der Stromfluss durch den Thyristor gestoppt werden kann.

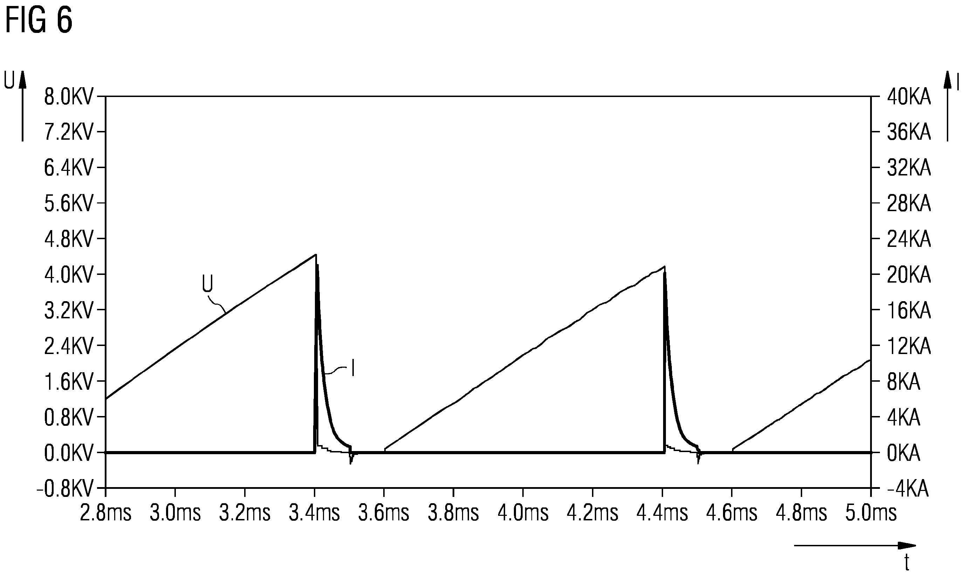

Fig. 6 zeigt ein Diagramm, das den Verlauf von Spannung und Strom durch das weitere steuerbare Halbleiterschaltelement zeigt. Gut zu erkennen ist, dass bei der Entladung des Kondensators 15 der Stromfluss über das weitere steuerbare Halbleiterschaltelement kurzzeitig ansteigt, wobei gleichzeitig die Spannung von einem Maximalwert auf null abfällt. Nach dem Entladen des Kondensators lädt sich der Kondensator 15 allmählich wieder auf, bis dieser wieder durch das weitere steuerbare Halbleiterschaltelement entladen wird.

Die beiden beschriebenen Varianten können anstelle der in Fig. 1 gezeigten Schaltvorrichtung in den Anordnungen gemäß den Figuren 2 und 3 eingesetzt werden.

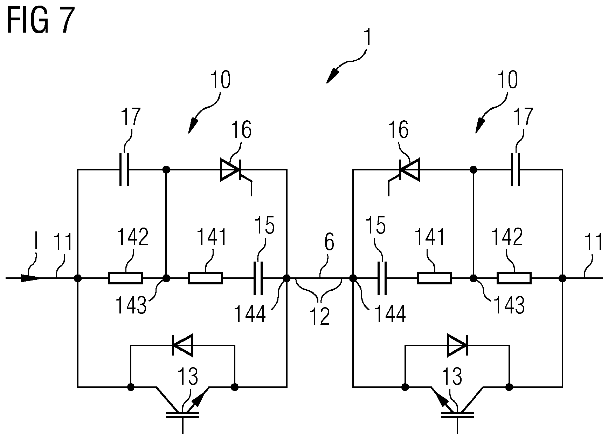

Durch antiserielle Verschaltung von zwei Modulen, wie diese in Fig. 4 gezeigt und beschrieben wurden, kann ein Schalter für bidirektionalen Betrieb realisiert werden. Dies ist in Fig. 7 dargestellt.

### Bezugszeichenliste

- 1: Schaltvorrichtung
- 2: Gleichspannungsquelle
- 3: quellseitige Induktivität
- 4: Last
- 5: lastseitige Induktivität
- 6: aufzutrennende Leitung
- 10: Schaltmodul
- 10-1, ..., 10-n: Schaltmodul
- 11: erster Schaltmodulanschluss
- 11-1, ..., 11-n: erster Schaltmodulanschluss
- 12: zweiter Schaltmodulanschluss
- 12-1, ..., 12-n: erster Schaltmodulanschluss
- 13: Halbleiterschaltelement
- 13-1, ..., 13-n: Halbleiterschaltelement
- 14: Widerstand
- 14-1, ..., 14-n: Widerstand
- 15: Kondensator
- 15-1, ..., 15-n: Kondensator
- 16: weiteres steuerbares Halbleiterschaltelement
- 17: weiterer Kondensator
- 141: Widerstand
- 142: Widerstand
- 143: erster Knotenpunkt
- 144: zweiter Knotenpunkt

- U: Spannung
- I: Strom
- t: Zeit

## Patentansprüche

1. Schaltvorrichtung (1) zum Auftrennen eines quell- und lastseitige Induktivitäten (3, 5) umfassenden Strompfads (6) eines Gleichspannungsnetzes, umfassend zumindest zwei in Serie verschaltete Schaltmodule (10), wobei jedes der Schaltmodule (10) zumindest ein steuerbares Halbleiterschaltelement (13) umfasst, dem eine Serienschaltung aus einem Widerstand (14) und einem Kondensator (15) parallel geschaltet ist, **dadurch gekennzeichnet, dass**
- der Widerstand (14) aus einer Serienschaltung von zwei seriell miteinander verschalteten Widerständen (141, 142) gebildet ist, wobei ein erstes Ende der Serienschaltung mit einem ersten Lastanschluss des steuerbaren Halbleiterschaltelements (13) und ein zweites Ende der Serienschaltung mit dem Kondensator (15) verschaltet ist, und
- jedes der Schaltmodule (10) ferner ein weiteres steuerbares Halbleiterschaltelement (16) umfasst, das direkt zwischen einem ersten Knotenpunkt (143) der beiden Widerstände der Serienschaltung und einem zweiten Knotenpunkt (144) verschaltet ist, der den Kondensator (15) mit einem zweiten Lastanschluss des steuerbaren Halbleiterschaltelements (13) verbindet.

2. Schaltvorrichtung nach Anspruch 1,
**dadurch gekennzeichnet, dass** das weitere steuerbare Halbleiterschaltelement (16) über ein Ansteuersignal leitend und sperrend schaltbar ist.

3. Schaltvorrichtung nach Anspruch 1 oder 2,
**dadurch gekennzeichnet, dass** das weitere steuerbare Halbleiterschaltelement (16) ein Bipolartransistor mit isolierter Gate-Elektrode (IGBT) ist.

4. Schaltvorrichtung nach Anspruch 1,
**dadurch gekennzeichnet, dass** das weitere steuerbare Halbleiterschaltelement (16) ein Thyristor ist.

5. Schaltvorrichtung nach Anspruch 4,
**dadurch gekennzeichnet, dass** der Thyristor vom abschaltbaren Typ (GTO, IGCT) ist.

6. Schaltvorrichtung nach Anspruch 4,
**dadurch gekennzeichnet, dass** der Thyristor mittels eines Löschkreises löschbar ist.

7. Schaltvorrichtung nach Anspruch 6,
**dadurch gekennzeichnet, dass** das steuerbare Halbleiterschaltelement (13) ein Element des Löschkreises ist.

8. Schaltvorrichtung nach Anspruch 6 oder 7,
**dadurch gekennzeichnet, dass** der Löschkreis einen weiteren Kondensator (17) umfasst, der zwischen dem ersten Knotenpunkt und dem ersten Lastanschluss des steuerbaren Halbleiterschaltelements (13) verschaltet ist.

9. Schaltvorrichtung nach einem der vorhergehenden Ansprüche,
**dadurch gekennzeichnet, dass** eine gewünschte Entladezeit des Kondensators (15) durch das Verhältnis der Widerstandswerte der Widerstände (141, 142) der Serienschaltung eingestellt ist.

## Claims

1. Switching device (1) for disconnecting a current path (6) in a DC supply system, said current path (6) comprising source-end and load-end inductances (3, 5), said switching device comprising at least two series-connected switching modules (10), wherein each of the switching modules (10) comprises at least one controllable semiconductor switching element (13), to which a series circuit consisting of a resistor (14) and a capacitor (15) is connected in parallel,
**characterized in that**
- the resistor (14) is formed from a series circuit of two series-connected resistors (141, 142), wherein a first end of the series circuit is connected to a first load terminal of the controllable semiconductor switching element (13) and a second end of the series circuit is connected to the capacitor (15), and
- each of the switching modules (10) also comprises a further controllable semiconductor switching element (16) which is connected directly between a first node (143) of the two resistors in the series circuit and a second node (144) which connects the capacitor (15) to a second load terminal of the controllable semiconductor switching element (13).

2. Switching device according to Claim 1,
**characterized in that** the further controllable semiconductor switching element (16) can be switched to a conducting state and a blocking state via a control signal.

3. Switching device according to Claim 1 or 2,
**characterized in that** the further controllable semiconductor switching element (16) is an insulated-gate bipolar transistor (IGBT) .

4. Switching device according to Claim 1,
**characterized in that** the further controllable semiconductor switching element (16) is a thyristor.

5. Switching device according to Claim 4,
**characterized in that** the thyristor is of the disconnectable type (GTO, IGCT).

6. Switching device according to Claim 4,
**characterized in that** the thyristor can be turned off by means of a turn-off circuit.

7. Switching device according to Claim 6,
**characterized in that** the controllable semiconductor switching element (13) is an element of the turn-off circuit.

8. Switching device according to Claim 6 or 7,
**characterized in that** the turn-off circuit comprises a further capacitor (17) which is connected between the first node and the first load terminal of the controllable semiconductor switching element (13).

9. Switching device according to one of the preceding claims,
**characterized in that** a desired discharge time of the capacitor (15) is set by means of the ratio of the resistance values of the resistors (141, 142) in the series circuit.

## Revendications

1. Montage (1) de coupure pour le sectionnement d'un trajet (6) de courant, comprenant des inductances (3, 5) du côté d'une source et du côté d'une charge, d'un réseau de tension continue, comprenant au moins deux modules (10) de coupure montés en série, dans lequel chacun des modules (10) de coupure comprend au moins un élément (13) de coupure à semiconducteur qui peut être commandé et avec lequel est monté en parallèle un circuit série composé d'une résistance (14) et d'un condensateur (15),
**caractérisé en ce que**
- la résistance (14) est formée d'un circuit série de deux résistances (141, 142) montées en série l'une avec l'autre, dans lequel une première extrémité du circuit série est connectée à une première borne de charge de l'élément (13) de coupure à semiconducteur qui peut être commandée et une deuxième extrémité du circuit série est connectée au condensateur (15), et
- chacun des modules (10) de coupure comprend en outre un autre élément (16) de coupure à semiconducteur, qui peut être commandé et qui est monté directement entre un premier point (143) nodal des deux résistances du circuit série et un deuxième point (144) nodal, qui relie le condensateur (15) à une deuxième borne de charge de l'élément (13) de coupure à semiconducteur qui peut être commandé.

2. Montage de coupure suivant la revendication 1,
**caractérisé en ce que** l'autre élément (16) de coupure à semiconducteur qui peut être commandé peut être mis à l'état passant et à l'état bloqué par un signal de commande.

3. Montage de coupure suivant la revendication 1 ou 2,
**caractérisé en ce que** l'autre élément (16) de coupure à semiconducteur qui peut être commandé est un transistor bipolaire à électrode de grille isolé (IGBT).

4. Montage de coupure suivant la revendication 1,
**caractérisé en ce que** l'autre élément (16) de coupure à semiconducteur qui peut être commandé est un thyristor.

5. Montage de coupure suivant la revendication 4,
**caractérisé en ce que** le thyristor est du type pouvant être ouvert (GTO, IGCT).

6. Montage de coupure suivant la revendication 4,
**caractérisé en ce que** le thyristor est effaçable au moyen d'un circuit d'effacement.

7. Montage de coupure suivant la revendication 6,
**caractérisé en ce que** l'élément (13) de coupure à semiconducteur qui peut être commandé est un élément du circuit d'effacement.

8. Montage de coupure suivant la revendication 6 ou 7,
**caractérisé en ce que** le circuit d'effacement comprend un autre condensateur (17), qui est monté entre le premier point nodal et la première borne de charge de l'élément (13) de coupure à semiconducteur qui peut être commandé.

9. Montage de coupure suivant l'une des revendications précédentes,
**caractérisé en ce qu'**un temps de décharge souhaité du condensateur (15) est réglé par le rapport des valeurs des résistances (141, 142) du circuit série.
